# EUROPEAN PATENT APPLICATION

(11) **EP 4 345 919 A1**
(43) Date of publication of application: **03.04.2024**
(21) Application number: 23199813.9
(22) Date of filing: 26.09.2023
(51) Int. Cl.: H01L 31/111, H01L 31/0224, H01L 31/0304, H01L 31/0352, H01L 31/18

(54) **LIGHT-TRIGGERED THYRISTOR AND METHOD OF FABRICATION OF SUCH THYRISTOR**

(30) Priority: 30.09.2022 PL 44242822
(71) Applicant: Instytut Wysokich Cisnien Polskiej Akademii Nauk, 01-142 Warszawa (PL)
(72) Inventor: MUZIOL , Grzegorz, 01-466 Warszawa (PL); SIEKACZ, Marcin, 03-395 Warszawa (PL); HAJDEL, Mateusz, 81-173 Gdynia (PL); BERCHA, Artem, 01-161 Warszawa (PL); SKIERBISZEWSKI, Czeslaw, 05-502 Kamionka (PL)
(74) Representative: Adamczyk, Piotr

(57) **Abstract**

The thyristor contains a semiconductor layered epitaxial structure (2-6), made of nitrides of group III metals and applied to a crystalline substrate (1), and a first (7) and a second (8) current terminal. In this structure (2-6), a first layer, counted from the aforementioned crystalline substrate (1), is a lower n-type conductivity layer (2) connected electrically with the second current terminal (8), and a last layer in this structure is an upper p-type conductivity layer (6) connected electrically with the first current terminal (7). A system of three layers (3-5) is located between the lower n-type conductivity layer (2) and the upper p-type conductivity layer (6) and the aforementioned system is formed by, counted from the crystalline substrate (1), a lower undoped layer (3), a layer producing piezoelectric charges (4) with the band gap that is lower than the band gap of the other layers (2, 3, 5, 6) of the aforementioned epitaxial structure, and an upper undoped layer (5). The layered structure of the thyristor is fabricated of nitrides of group III metals in the process of nitrogen plasma assisted molecular beam epitaxy (PAMBE) growth.

## Description

The present invention relates to a light-triggered thyristor and to a method of fabrication of such a thyristor.

Thyristors are applied widely as solid-state relays and protection systems because they can be triggered to the conduction state by means of an electric signal. Examples of silicon thyristors are disclosed in US2655610A. A typical thyristor contains four epitaxial layers characterised by a variable conduction type, *n-p-n-p* or *p-n-p-n,* and three terminals connected with such a structure, the middle terminal of which serves for feeding the switching signal. Such a configuration of layers causes the formation of a potential barrier, which prevents an effective flow of electrons and holes. The thyristor is opened by applying the potential to the middle terminal, which is connected electrically with one of the inner layers of the thyristor's layered structure. As a result, the potential barrier that blocks the flow of the carriers is cancelled and the intensity of the current flowing through the thyristor increases significantly.

Historically, silicon thyristors were succeeded by thyristors based on other semiconductor materials. US4829357A discloses examples of thyristors built with the use of gallium arsenide, while US5539217A describes thyristors that use silicon carbide. Thyristors based on silicon carbide gained a strong interest due to the high band gap value, the high thermal conduction, and the high value of the breakdown field of this material. Thanks to that, thyristors based on silicon carbide are particularly appreciated in applications that require a high breakdown voltage and operation at a high temperature.

Optically-triggered thyristors, also known as optical thyristors, are a special class of thyristors. The first device of this type is disclosed in US4806997A. An optical thyristor contains only two terminals and such a thyristor is triggered with the use of light. This solution simplifies the electrical connections, eliminates unwanted excitations of the integrated instruments and provides galvanic isolation.

An optical thyristor disclosed in US4806997A is closest to the invention. Its fabrication requires fabrication of alternately placed n-p-n-p-type doped and p-n-p-n-type doped layers, the same as in thyristors with three terminals. In the described instrument, current terminals are connected to the outer n-type and p-type layers, while the inner layers form a p-n junction. In this configuration, there is a potential barrier in the thyristor. When the thyristor is illuminated, the potential barrier is reduced and the intensity of the current flowing between the terminals increases. However, due to the necessity to fabricate p-type layers surrounded by n-type layers, this solution is not applied in thyristors based on gallium nitride.

Object of the invention is to obtain a light-triggered thyristor based on a nitride of group III metals, for example on gallium nitride.

This object is achieved by a thyristor according to the invention, which contains a semiconductor layered epitaxial structure applied to a crystalline substrate and a first and a second current terminal. In this structure, a first layer, counted from the aforementioned crystalline substrate, is a lower n-type conductivity layer connected electrically with the second current terminal, and a last layer in this structure is an upper p-type conductivity layer connected electrically with the first current terminal. The invention is characterised in that the semiconductor layered epitaxial structure is made of nitrides of group III metals. A system of three layers is located between the lower n-type conductivity layer and the upper p-type conductivity layer and the aforementioned system is formed by, counted from the crystalline substrate, a lower undoped layer, a layer producing piezoelectric charges with the band gap that is lower than the band gap of the other layers of the aforementioned epitaxial structure, and an upper undoped layer.

In one of the variants of the thyristor according to the invention, the layer producing piezoelectric charges has the thickness ranging from 20 and 100 nm and is made of an indium gallium nitride alloy InₓGa₁₋ₓN, wherein the indium content *x* ranges from 0.02 to 0.30.

In another variant of the thyristor according to the invention, the layer producing piezoelectric charges has the thickness ranging from 40 and 1000 nm and is made of a stack of sublayers with the thickness of each sublayer ranging from 20 to 100 nm. This stack contains alternately placed sublayers: counted from the crystalline substrate, a sublayer made of an indium gallium nitride alloy InₓGa₁₋ₓN, wherein the indium content *x* ranges from 0.02 to 0.30, and a sublayer made of an aluminium gallium nitride alloy Al_{y}Ga_{1-y}N, wherein the aluminium content y ranges from 0.01 to 0.40.

In another variant of the thyristor according to the invention, both undoped layers are made of gallium nitride, and their non-intentional doping does not exceed 1 × 10¹⁷cm⁻³. The thickness of the lower undoped layer ranges from 100 to 300 nm, and the thickness of the upper undoped layer ranges from 100 to 1000 nm.

In another variant of the thyristor according to the invention, the lower n-type conductivity layer is made of gallium nitride, while the n-type doping level of this layer ranges from 1 × 10¹⁷cm⁻³ to 5 × 10¹⁸cm⁻³.

In another variant of the thyristor according to the invention, the upper p-type conductivity layer is made of gallium nitride, while the p-type doping level of this layer ranges from 1 × 10¹⁹cm⁻³ to 1 × 10²⁰cm⁻³.

In still another variant of the thyristor according to the invention, the region of the first current terminal which is in contact with the upper p-type conductivity layer contains at least one square window with the side length ranging from 1 to 10 µm. A method of fabrication of the thyristor according to the invention consists in fabricating a semiconductor layered epitaxial structure on a crystalline substrate, in which structure the first layer, counted from the aforementioned crystalline substrate, is the lower n-type conductivity layer connected electrically with the second current terminal, and the last layer in this structure is the upper p-type conductivity layer connected electrically with the first current terminal. The method is characterised in that the layered semiconductor structure is fabricated of nitrides of group III metals in the process of nitrogen plasma assisted molecular beam epitaxy (PAMBE) growth. A system of three layers is fabricated between the lower n-type conductivity layer and the upper p-type conductivity layer and the aforementioned system is formed by, counted from the crystalline substrate, a lower undoped layer, a layer producing piezoelectric charges, and an upper undoped layer. The band gap of the material of the layer producing piezoelectric charges is lower than the band gap of the other layers of the thyristor's epitaxial structure.

In one of the variants of the method according to the invention, a layer producing piezoelectric charges, which has the thickness ranging from 20 and 100 nm and is made of an indium gallium nitride alloy InₓGa₁₋ₓN, wherein the indium content *x* ranges from 0.02 to 0.30, is applied to the lower undoped layer.

In another variant of the method according to the invention, a layer producing piezoelectric charges, which has the thickness ranging from 40 and 1000 nm and is made of a stack of sublayers with the thickness of each sublayer ranging from 20 to 100 nm, is applied to the lower undoped layer. This stack contains alternately placed sublayers: a sublayer made of an indium gallium nitride alloy InₓGa₁₋ₓN, wherein the indium content x ranges from 0.02 to 0.30, and a sublayer made of an aluminium gallium nitride alloy Al_{y}Ga_{1-y}N, wherein the aluminium content y ranges from 0.01 to 0.40. A sublayer made of an InₓGa₁₋ₓN alloy is applied directly to the lower undoped layer.

In another variant of the method according to the invention, both undoped layers are made of gallium nitride, wherein their non-intentional doping does not exceed 1 × 10¹⁷cm⁻³. The thickness of the lower undoped layer ranges from 100 to 300 nm, and the thickness of the upper undoped layer ranges from 100 to 1000 nm.

In another variant of the method according to the invention, the lower n-type conductivity layer is made of gallium nitride, wherein the n-type doping level of this layer ranges from 1 × 10¹⁷cm⁻³ to 5 × 10¹⁸cm⁻³.

In another variant of the method according to the invention, the upper p-type conductivity layer is made of gallium nitride, wherein the p-type doping level of this layer ranges from 1 × 10¹⁹cm⁻³ to 1 × 10²⁰cm⁻³.

In another variant of the method according to the invention, at least one square window with the side length ranging from 1 to 10 µm is fabricated in the lithography and etching process in the region of the first current terminal which is in contact with the upper p-type conductivity layer.

In still another variant of the method according to the invention, the growth of the semiconductor layered epitaxial structure of the thyristor is performed in metal-rich conditions and at the temperature ranging from 600°C to 780°C, while nitrogen for epitaxial growth of this structure is supplied in the form of plasma excited by a power supply unit generating a power between 350 and 500 W, with the nitrogen flow between 1 and 3 millilitres per minute.

The invention breaks the conviction, which prevails among specialists, that it is impossible to fabricate a thyristor based on nitrides of group III metals for three reasons. The first reason is the low value of the free path of minority carriers in gallium nitride (e.g. Z.Z. Bandic et al., Solid-State Electronics 44, 221 (2000)) and M Trivedi et al., Journal of Applied Physics 88, 7313 (2000)). The low free path of electrons in magnesium-doped layers causes a high voltage in the ON state of the thyristor. It turned out unexpectedly that the replacement of a p-type layer by a positive charge present between two undoped layers causes a significant reduction of the ON state voltage of the thyristor. The second reason for which it seemed impossible to fabricate a thyristor based on nitrides of group III metals is the so-called magnesium memory effect. This is a considerable technological impediment in achieving the n-type conductivity in the layers that are grown after the magnesium-doped layers in the most popular growth technology, being MOCVD (metalorganic chemical vapour deposition). In the case of the MOCVD technology, the reactor becomes contaminated with magnesium after the growth of the layers that are doped with this element and the further growth of n-type doped layers is impeded. This problem is widely known among specialists and is described, for example, in the publication in the Journal of Crystal Growth 145, 214 (1994) and in the publication in the Jpn. J.Appl. Phys. Vol. 42, 50 (2003). The third reason for which it seemed impossible to fabricate a thyristor based on nitrides of group III metals is the problem with achieving p-type conductivity of layers that are surrounded by n-type layers. It is widely known that in order to achieve p-type conductivity in magnesium-doped layers that were fabricated with the use of the MOCVD technology, it is necessary to anneal the layered structure at a high temperature in the nitrogen atmosphere, which is described in the publication in the Jpn. J. Appl. Phys. 31 L139 (1992). The annealing of p-type layers that are surrounded by n-type layers does not cause activation of the magnesium dopant due to the virtually zero diffusion of hydrogen through the n-type doped layers, which is described in the publication in the Journal of Alloys and Compounds 747, 354 (2018). As a result, it is technologically impossible to fabricate a thyristor wherein at least one p-type layer is surrounded by n-type layers. It turned out unexpectedly that the replacement of a p-type layer by a positive charge present between two undoped layers and the replacement of an n-type layer by a negative charge present between the aforementioned undoped layers eliminates the problems related to the magnesium memory effect and to the activation of the magnesium dopant and thereby makes it possible to obtain a thyristor.

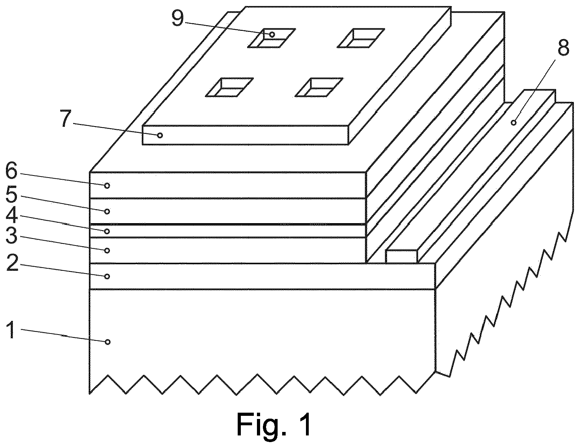

The invention in the embodiment described below is reflected in a drawing, with Fig.1 presenting schematically the structure of the thyristor according to the invention in the axonometric view, Fig.2 presenting the current-voltage characteristics of said thyristor, Fig.3 presenting the current-voltage characteristics during the illumination that triggers said thyristor, and Fig.4 presenting the band structure of said thyristor.

The embodiment of the thyristor described below contained a semiconductor layered epitaxial structure applied to the crystalline substrate 1, in which structure the first layer, counted from the aforementioned crystalline substrate 1, is the lower n-type conductivity layer 2. A lower undoped layer 3, a layer producing piezoelectric charges 4, an upper undoped layer 5, and an upper p-type conductivity layer 6 are present successively on the layer 2. Said structure was fabricated by molecular beam epitaxy on the crystalline substrate 1 made of gallium nitride with the thickness of 350 µm. In order to fabricate the aforementioned layered structure, the substrate 1 was annealed in the prechamber of the reactor at the temperature of 150°C for five hours. Subsequently, the substrate 1 was annealed for 30 minutes in the preparatory chamber at the temperature of 650°C. The epitaxy of the thyristor's layered structure was performed in the growth chamber in metal-rich conditions. As a source of active nitrogen for the growth, nitrogen plasma excited by a power supply unit generating a power of 430 W, with the nitrogen flow of 1.5 sccm, was used. At the temperature of 730°C, the lower n-type conductivity layer 2 with the thickness of 200 nm made of gallium nitride doped with silicon in the amount of 2 × 10¹⁸ cm⁻³ was applied to the substrate 1, and subsequently the lower undoped layer 3 with the thickness of 200 nm made of gallium nitride was applied. Subsequently, the growth temperature was reduced to 650°C and a layer producing piezoelectric charges 4 with the thickness of 50 nm, which was made of In_{0.12}Ga_{0.88}N alloy, whose band gap is 3.0 eV and is 0.4 eV lower than the band gap of gallium nitride, was applied. Subsequently, the temperature in the growth chamber was increased to 730°C and the upper undoped layer 5 with the thickness of 200 nm was fabricated of gallium nitride, and subsequently the upper p-type doped layer 6 with the thickness of 40 nm was fabricated of GaN doped with magnesium in the amount of 3 × 10¹⁹cm⁻³. The layered structure (2-6) fabricated by epitaxy was subjected to photolithography and etching by the RIE (Reactive Ion Etching) method in order to form single devices and to uncover the lower n-type doped layer 2. The etching was performed to the depth of 490 nm, which was up to the level of the lower n-type doped layer 2. At the subsequent stage, the first current terminal 7 made of Ni/Au with the thickness of 25nm/75nm was applied to the upper p-type doped layer 6 according to a known method. Subsequently, openings 9 with the shape of square with the side length of 5 µm were made in the current terminal 7 by the photolithography and RIE methods. The distances between the adjacent square openings 5 were 5 µm. Subsequently, the second current terminal 8 with the thickness of 40nm/60nm/25nm/75nm made of Ti/Al/Ni/Au, respectively, was applied to the lower n-type doped layer 2 according to a known method. At the end, the structure was divided into individual devices with the dimensions of 300 × 300 × 350 µm and said devices were installed in enclosures. In the embodiment of the thyristor described above, alternatively the layer producing piezoelectric charges 4 can be composed of a stack of five sublayers made of an indium gallium nitride alloy and of an aluminium gallium nitride alloy, which are placed alternately. The first sublayer made of In_{0.12}Ga_{0.88}N was applied in the same manner as described above to the lower undoped layer 3. After increasing the growth temperature to 730°C, the second sublayer made of Al_{0.06}Ga_{0.94}N was applied. Subsequently, the third sublayer made of In_{0.12}Ga_{0.88}N was applied at the temperature of 650°C, and the fourth sublayer made of Al_{0.06}Ga_{0.94}N was applied at the temperature of 730°C. The application of the layer producing piezoelectric charges 4 was finished by the application of the fifth sublayer made of In_{0.12}Ga_{0.88}N at the temperature of 650°C. The thickness of each of the aforementioned sublayers was 20 nm. Subsequent layers of the epitaxial structure (5, 6) and both current terminals 7 and 8 were applied according to the aforementioned method to thus fabricated alternative layer producing piezoelectric charges 4.

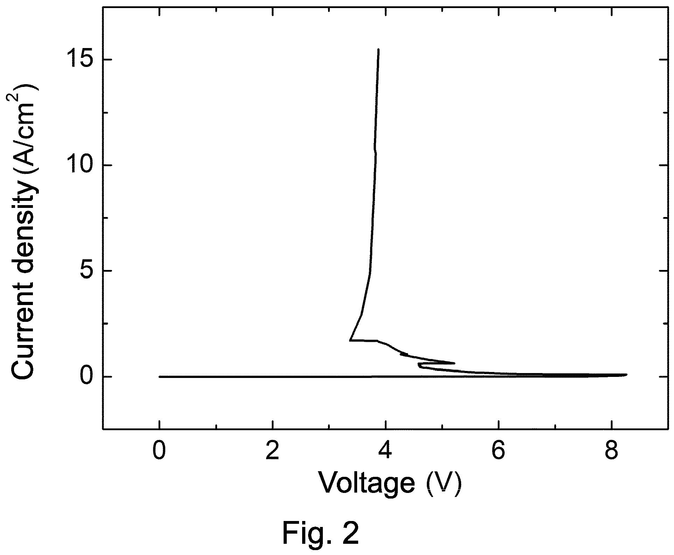

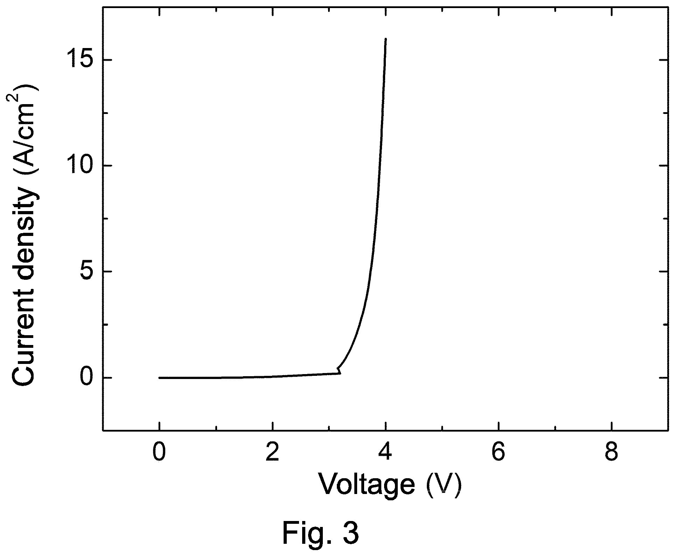

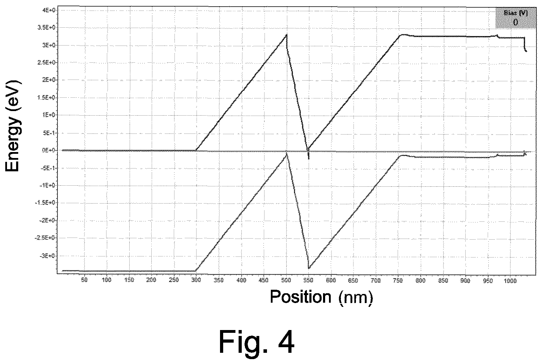

As reflected in Fig.2, a thyristor obtained according to the above method is characterised by a high electric voltage of up to 8.3 V at low current densities. At higher current densities, the voltage decreases, which is caused by the screening of the piezoelectric charges and by the reduction of the energy barrier formed by said charges. Fig.3 shows that said barrier is no longer present during the illumination of the thyristor and the voltage is low already starting from low current densities. In the power supply mode, in which voltage is stabilised in the range from 4 to 8 V, the illumination of the thyristor results in the thyristor opening and in a considerable current increment. Fig.4 presents the profile of the conduction band minimum and the profile of the valence band maximum of the thyristor with the visible energy barrier which is formed as a result of the presence of piezoelectric charges.

In the embodiment of the thyristor according to the invention described above, a negative electric charge is present on the border between the lower undoped layer 3 and the layer producing piezoelectric charges 4, while a positive electric charge is present on the border between the layer producing piezoelectric charges 4 and the upper undoped layer 5. These charges are formed because a material which is characterised by a high piezoelectric coefficient and by a lattice misfit with the substrate was used as the layer producing piezoelectric charges 4. The negative charge present on the border between the layers 3 and 4 causes the formation of a potential barrier for the electron flow in the direction from terminal 8 to terminal 7. The positive charge present on the border between the layers 4 and 5 causes the formation of a potential barrier for the hole flow in the direction from terminal 7 to terminal 8. The illumination of the thyristor with light through the openings 9 in the terminal 7, with an energy above the value of the band gap of the material applied as the layer producing piezoelectric charges 4 causes the formation of electron-hole pairs inside the layer producing piezoelectric charges 4. Subsequently, the electron-hole pairs are separated as a result of the built-in electric field, the electrons are aggregated in the vicinity of the positive charge on the border between the layers 4 and 5, while the holes are aggregated in the vicinity of the negative charge on the border between the layers 3 and 4. The aggregation of the electrons and the holes leads to the screening of the charges on the borders between the layers 4 and 5 and on the borders between the layers 3 and 4, respectively. The screening of said charges leads to the elimination of the potential barriers and to the free electron flow in the direction from the terminal 8 to the terminal 7 and to the hole flow in the direction from the terminal 7 to the terminal 8. Such a structure enables the control of the current flow with the use of light.

## Claims

1. A light-triggered thyristor, which contains a semiconductor layered epitaxial structure applied to a crystalline substrate and a first and a second current terminal, in which structure a first layer, counted from the aforementioned crystalline substrate, is a lower n-type conductivity layer connected electrically with the second current terminal, and a last layer in this structure is an upper p-type conductivity layer connected electrically with the first current terminal, **characterised in that** the semiconductor layered epitaxial structure is made of nitrides of group III metals, a system of three layers is located between the lower n-type conductivity layer (2) and the upper p-type conductivity layer (6) and the aforementioned system is formed by, counted from the crystalline substrate (1), a lower undoped layer (3), a layer producing piezoelectric charges (4) with the band gap that is lower than the band gap of the other layers (2, 3, 5, 6) of the aforementioned epitaxial structure, and an upper undoped layer (5).

2. The thyristor according to claim 1, **characterised in that** the layer producing piezoelectric charges (4) has the thickness ranging from 20 and 100 nm and is made of an indium gallium nitride alloy InₓGa₁₋ₓN, wherein the indium content *x* ranges from 0.02 to 0.30.

3. The thyristor according to claim 1, **characterised in that** the layer producing piezoelectric charges (4) has the thickness ranging from 40 and 1000 nm and is made of a stack of sublayers with the thickness of each sublayer ranging from 20 to 100 nm, which stack contains alternately placed sublayers: counted from the crystalline substrate (1), a sublayer made of an indium gallium nitride alloy InₓGa₁₋ₓN, wherein the indium content *x* ranges from 0.02 to 0.30, and a sublayer made of an aluminium gallium nitride alloy Al_{y}Ga_{1-y}N, wherein the aluminium content y ranges from 0.01 to 0.40.

4. The thyristor according to claim 1 or 2 or 3, **characterised in that** both undoped layers (3, 5) are made of gallium nitride, and their non-intentional doping does not exceed 1 × 10¹⁷cm⁻³, wherein the thickness of the lower undoped layer (3) ranges from 100 to 300 nm, and the thickness of the upper undoped layer (5) ranges from 100 to 1000 nm.

5. The thyristor according to claim 1 or 2 or 3 or 4, **characterised in that** the lower n-type conductivity layer (2) is made of gallium nitride, while the n-type doping level of this layer (2) ranges from 1 × 10¹⁷cm⁻³ to 5 × 10¹⁸cm⁻³.

6. The thyristor according to claim 1 or 2 or 3 or 4 or 5, **characterised in that** the upper p-type conductivity layer (6) is made of gallium nitride, while the p-type doping level of this layer (6) ranges from 1 × 10¹⁹cm⁻³ to 1 × 10²⁰cm⁻³.

7. The thyristor according to claim 1 or 2 or 3 or 4 or 5 or 6, **characterised in that** the region of the first current terminal (7) which is in contact with the upper p-type conductivity layer (6) contains at least one square window (9) with the side length ranging from 1 to 10 µm.

8. A method of fabrication of a light-triggered thyristor, consisting in fabricating a semiconductor layered epitaxial structure on a crystalline substrate, in which structure a first layer, counted from the aforementioned crystalline substrate, is a lower n-type conductivity layer connected electrically with a second current terminal, and a last layer in this structure is an upper p-type conductivity layer connected electrically with a first current terminal, **characterised in that** the layered semiconductor structure is fabricated of nitrides of group III metals in the process of nitrogen plasma assisted molecular beam epitaxy (PAMBE) growth, a system of three layers is fabricated between the lower n-type conductivity layer (2) and the upper p-type conductivity layer (6) and the aforementioned system is formed by, counted from the crystalline substrate (1), a lower undoped layer (3), a layer producing piezoelectric charges (4) with the band gap that is lower than the band gap of the other layers (2, 3, 5, 6) of the aforementioned epitaxial structure, and an upper undoped layer (5).

9. The method according to claim 8, **characterised in that** a layer producing piezoelectric charges (4), which has the thickness ranging from 20 and 100 nm and is made of an indium gallium nitride alloy InₓGa₁₋ₓN, wherein the indium content *x* ranges from 0.02 to 0.30, is applied to the lower undoped layer (3).

10. The method according to claim 8, **characterised in that** a layer producing piezoelectric charges (4), which has the thickness ranging from 40 and 1000 nm and is made of a stack of sublayers with the thickness of each sublayer ranging from 20 to 100 nm, is applied to the lower undoped layer (3), which stack contains alternately placed sublayers: a sublayer made of an indium gallium nitride alloy InₓGa₁₋ₓN, wherein the indium content *x* ranges from 0.02 to 0.30, and a sublayer made of an aluminium gallium nitride alloy Al_{y}Ga_{1-y}N, wherein the aluminium content *y* ranges from 0.01 to 0.40, wherein a sublayer made of an InₓGa₁₋ₓN alloy is applied directly to the lower undoped layer (3).

11. The method according to claim 8 or 9 or 10, **characterised in that** both undoped layers (3, 5) are made of gallium nitride, wherein their non-intentional doping does not exceed 1 × 10¹⁷cm⁻³, and the thickness of the lower undoped layer (3) ranges from 100 to 300 nm, and the thickness of the upper undoped layer (5) ranges from 100 to 1000 nm.

12. The method according to claim 8 or 9 or 10 or 11, **characterised in that** the lower n-type conductivity layer (2) is made of gallium nitride, wherein the n-type doping level of this layer (2) ranges from 1 × 10¹⁷cm⁻³ to 5 × 10¹⁸cm⁻³.

13. The method according to claim 8 or 9 or 10 or 11 or 12, **characterised in that** the upper p-type conductivity layer (6) is made of gallium nitride, wherein the p-type doping level of this layer (6) ranges from 1 × 10¹⁹cm⁻³ do 1 × 10²⁰cm⁻³.

14. The method according to claim 8 or 9 or 10 or 11 or 12 or 13, **characterised in that** at least one square window (9) with the side length ranging from 1 to 10 µm is fabricated in the lithography and etching process in the region of the first current terminal (7) which is in contact with the upper p-type conductivity layer (6).

15. The method according to claim 8 or 9 or 10 or 11 or 12 or 13 or 14, **characterised in that** the growth of the semiconductor layered epitaxial structure (2-6) is performed in metal-rich conditions and at the temperature ranging from 600°C to 780°C, while nitrogen for epitaxial growth of this structure (2-6) is supplied in the form of plasma excited by a power supply unit generating a power between 350 and 500 W, with the nitrogen flow between 1 and 3 millilitres per minute.
